# EUROPÄISCHE PATENTSCHRIFT

(11) **EP 2 577 862 B1**
(45) Veröffentlichungstag und Bekanntmachung des Hinweises auf die Patenterteilung: **12.06.2019**
(21) Anmeldenummer: 11714758.7
(22) Anmeldetag: 14.04.2011
(51) Int. Cl.: G01R 19/175, H02P 6/182, H02P 6/18

(54) **VERFAHREN UND VORRICHTUNG ZUM ERMITTELN EINES NULLDURCHGANGS EINES STRANGSTROMS EINER ELEKTRONISCH KOMMUTIERTEN ELEKTRISCHEN MASCHINE, INSBESONDERE ZUR ERMITTLUNG EINER LÄUFERLAGE DER ELEKTRISCHEN MASCHINE**
METHOD AND APPARATUS FOR DETERMINING A ZERO CROSSING OF A PHASE CURRENT OF AN ELECTRONICALLY COMMUTATED ELECTRICAL MACHINE, IN PARTICULAR FOR DETERMINING A ROTOR POSITION OF THE ELECTRICAL MACHINE
PROCÉDÉ ET DISPOSITIF POUR LA DÉTERMINATION D'UN PASSAGE PAR ZÉRO D'UN COURANT DE PHASE D'UNE MACHINE ÉLECTRIQUE COMMUTÉE ÉLECTRONIQUEMENT, EN PARTICULIER POUR LA DÉTERMINATION D'UNE POSITION DU ROTOR DE LA MACHINE ÉLECTRIQUE

(30) Priorität: 01.06.2010 DE 102010029558
(43) Veröffentlichungstag der Anmeldung: 10.04.2013
(73) Patentinhaber: Robert Bosch GmbH, 70442 Stuttgart (DE)
(72) Erfinder: FRICKER, David, F-67240 Oberhoffen Sur Moder (FR)
(86) Internationale Anmeldenummer: PCT/EP2011/055882
(87) Internationale Veröffentlichungsnummer: WO 2011/151101

(56) Entgegenhaltungen:
- DE-A1- 19 846 831
- DE-A1-102008 018 811

## Beschreibung

### Technisches Gebiet

Die Erfindung betrifft elektrische Maschinen, insbesondere elektronisch kommutierte elektrische Maschinen, bei denen zur Ansteuerung, insbesondere zur Ermittlung der Läuferlage, ein Nulldurchgang eines Strangstroms detektiert wird.

### Stand der Technik

Elektronisch kommutierte elektrische Maschinen, wie z.B. Synchronmotoren, Asynchronmotoren und dergleichen, sind aus dem Stand der Technik bekannt. Eine derartige elektrische Maschine weist einen passiven Läufer auf, der z.B. mit Permanentmagneten versehen sein kann, um Läuferpole auszubilden. Auf den Läufer wird durch Erzeugen eines äußeren Magnetfelds eine Antriebskraft ausgeübt. Das äußere Magnetfeld muss abhängig von der aktuellen Läuferlage generiert werden, so dass zur Ansteuerung einer solchen elektronisch kommutierten elektrischen Maschine eine Kenntnis über die momentane Läuferlage des Läufers notwendig ist.

Das äußere Magnetfeld wird mit Hilfe einer Statorwicklung mit in der Regel mehreren Phasen erzeugt. Die Läuferlage wird dazu genutzt, die an die Statorwicklung anzulegenden Phasenspannungen zu bestimmen und diese an Phasenstränge der Statorwicklung anzulegen.

Die Ansteuerung der elektrischen Maschine erfolgt mit Hilfe einer Treiberschaltung, die häufig mit Hilfe von Inverterschaltungen ausgebildet sind, um die Phasenstränge der elektrischen Maschine mit Hilfe von H-Brücken- oder B6-Brückenschaltungen anzusteuern. Die Ansteuerung erfolgt gemäß einem von der momentanen Läuferlage abhängigen Bestromungsmuster, das so gewählt ist, dass ein durch die Phasenspannung erzeugtes Statormagnetfeld dem Erregermagnetfeld der Permanentmagneten im Läufer in Drehrichtung voreilend bereitgestellt wird, um ein Antriebsmoment bereitzustellen.

Verfahren zur Erfassung der Läuferlage sind aus dem Stand der Technik hinreichend bekannt. Einerseits kann die aktuelle Läuferlage mit Hilfe eines Lagedetektors detektiert werden, der eine Angabe über die momentane Läuferlage anhand eines analogen oder digitalen Messsignals einer entsprechenden Ansteuereinheit für die elektrische Maschine bereitstellt. Derartige Lagedetektoren können mit Hilfe von mehreren Hall-Sensoren oder GMR-Sensoren (GMR: Giant Magnetic Resistance) die momentane Läuferlage detektieren. Dazu können diese nahe den Läuferpolen des Läufers oder an einem magnetischen Geberrad angeordnet sein und die Lage des Läufers anhand der Stärke und Richtung des durch die Lagedetektoren gemessenen Magnetfeldes angeben.

Andererseits kann die Läuferlage des Läufers der elektrischen Maschine auch gemäß einem so genannten Back-EMF Verfahren durch Auswerten eines Verlaufes einer induzierten Spannung im stromlosen Zustand eines betreffenden Phasenstrangs der Statorwicklung detektiert werden. Dazu wird zunächst der Nulldurchgang eines Strangstroms in dem betreffenden Phasenstrang detektiert bzw. prädiziert und die Spannungsversorgung für die Phasenspannung an dem Phasenstrang für ein vorgegebenes Messzeitfenster, das den Nulldurchgang umfasst, deaktiviert. Während des Messzeitfensters wird der Verlauf der induzierten Spannung ermittelt und anhand des Verlaufes der induzierten Spannung der Nulldurchgangs-Zeitpunkt eines Nulldurchgangs der induzierten Spannung errechnet. Der Nulldurchgangs-Zeitpunkt der induzierten Spannung kann eine Angabe für die momentane Läuferlage darstellen.

Bislang wird die Erfassung des Nulldurchgangs des Strangstroms in einem oder in mehreren der Phasenstränge durch Messen eines Spannungsabfalls über einen Messwiderstand (Shunt) oder eines Spannungsabfalls über einen der Leistungsschalter in der Treiberschaltung festgestellt. Diese Verfahren sind jedoch aufwendig und erfordern das Vorsehen von zusätzlichen Maßnahmen, um den Stromverlauf eines Strangstroms zu überwachen, um dessen Nulldurchgang feststellen zu können. Zudem müssen bei Verwendung von Messwiderständen diese in Serie mit den Phasensträngen geschaltet werden, wobei Verluste auftreten, die den Wirkungsgrad des Motorsystems beeinträchtigen können.

Die Druckschrift DE 10 2008 018 811 A1 offenbart ein Verfahren zur Bestimmung des Stromnulldurchgangs eines Stroms zumindest einer Phase eines mehrphasigen Elektromotors. Die Spannung der Phase wird am Ende von Totzeitintervallen gemessen, in denen die Halbleiterschalter der der Phase zugeordneten Halbleiterbrücke ausgeschaltet sind. Es wird ein erster Phasenwinkel bei Auftreten eines ersten Vorzeichenwechsels der gemessenen Phasenspannung und ein zweiter Phasenwinkel bei Auftreten eines dem ersten Vorzeichenwechsel entgegengesetzten zweiten Vorzeichenwechsels der gemessenen Phasenspannung ermittelt, das arithmetische Mittel gebildet und der Stromnulldurchgang des Stroms der Phase aus dem arithmetischen Mittel und einer Winkelverschiebung von 90° berechnet.

Die Druckschrift DE 19 846 831 A1 offenbart ein Verfahren zur Ermittlung der Drehstellung des Rotors eines Synchronmotors. Die momentane Rotorstellung wird durch Messen der in mindestens einer Statorwicklung durch den Rotor induzierten EMK in einer Stromlücke des durch diese Statorwicklung fließenden Statorstroms ermittelt, wobei bei Verwendung eines sinusförmigen oder quasi sinusförmigen Statorstroms eine künstliche Stromlücke erzeugt wird.

Es ist daher Aufgabe der vorliegenden Erfindung, ein Verfahren und eine Vorrichtung zum Ermitteln eines Nulldurchgangs eines Strangstroms in einfacher Weise zu ermitteln, wobei insbesondere der Aufwand für konstruktive Maßnahmen reduziert ist.

### Offenbarung der Erfindung

Diese Aufgabe wird durch das Verfahren gemäß Anspruch 1 sowie durch eine Vorrichtung gemäß Anspruch 6 gelöst.

Weitere vorteilhafte Ausgestaltungen sind in den abhängigen Ansprüchen angegeben.

Gemäß einem ersten Aspekt ist ein Verfahren zum Ermitteln eines Zeitpunkts eines Nulldurchgangs eines Strangstroms in einer mehrphasigen elektrischen Maschine vorgesehen. Dabei wird die elektrische Maschine mit Hilfe einer Treiberschaltung mit Leistungsschaltern angesteuert, um mehrere Phasenspannungen bereitzustellen, die an entsprechenden Phasen zugeordnete Anschlussknoten der elektrischen Maschine angelegt werden, wobei zumindest ein Teil der Leistungsschalter gemäß einer Pulsweitenmodulation mit einem Tastverhältnis zyklisch ansteuerbar ist, um an einen der Anschlussknoten verschiedene Potenziale im Wechsel anzulegen. Das Verfahren umfasst folgende Schritte:
- Ansteuern der Treiberschaltung zum Bereitstellen der Phasenspannungen, um die elektrischen Maschine zu betreiben;
- Deaktivieren der pulsweitenmodulierten Ansteuerung für mindestens einen der Leistungsschalter, so dass zumindest während eines Zeitabschnitts in jedem Zyklus der Pulsweitenmodulation kein Potenzial durch die Treiberschaltung an den Anschlussknoten angelegt wird;
- Detektieren einer Diodenspannung über einer Freilaufdiode, mit der der deaktivierte Leistungsschalter versehen ist, innerhalb des Zeitabschnitts;
- Feststellen des Zeitpunkts des Nulldurchgangs des Strangstroms als den Zeitpunkt, ab dem innerhalb des Zeitabschnitts keine Diodenspannung über der Freilaufdiode mehr vorliegt.

Eine Idee des obigen Verfahrens besteht darin, das Auftreten eines Strangstroms anhand einer Diodenspannung über einer einem Leistungsschalter der Treiberschaltung zugeordneten Freilaufdiode zu erkennen. Wird einer der Leistungsschalter, der zuvor gemäß einer Pulsweitenmodulation betrieben worden ist, deaktiviert, so liegt zumindest in Zeitabschnitten, in denen der betreffende Leistungsschalter leitend geschaltet würde, das durch den Leistungsschalter zu schaltende Potenzial nicht an dem Anschlussknoten an. Dadurch ist der Anschlussknoten floatend (schwebend).

Aufgrund des Strangstroms wird die Freilaufdiode des deaktivierten Leistungsschalters in Durchlassrichtung betrieben und es fällt eine Diodenspannung ab, die das Potenzial auf dem Anschlussknoten prägt. Insbesondere ergibt sich an dem Anschlussknoten ein Potenzial, das sich aus der Diodenspannung und dem durch den deaktivierten Leistungsschalter aufzuschaltenden Potenzial ergibt. Die Spannung über der Diode entspricht bei einem Vorzeichenwechsel des Strangstroms einer Spannung, die durch den elektrischen Kreis bestimmt wird, da die Freilaufdiode nun in Sperrrichtung betrieben wird. Daher kann man durch Detektieren des Zeitpunktes, zu dem die Diodenspannung Null wird, den Zeitpunkt feststellen, ab dem die Freilaufdiode in Sperrrichtung betrieben wird. Dieser Zeitpunkt entspricht dem Zeitpunkt des Nulldurchgangs des Strangstroms.

Um den Strangstrom durch die Freilaufdiode fließen zu lassen, ist es notwendig, im Gegensatz zu dem herkömmlichen Ansteuerverfahren, bei dem die Leistungsschalter der Treiberschaltung gemäß einem Tastverhältnis einer Pulsweitenmodulation wechselseitig betrieben werden, einen der Leistungsschalter zu deaktivieren, und einen Diodenstrom durch die dem deaktivierten Leistungsschalter zugeordnete Freilaufdiode zuzulassen.

Das Detektieren des Zeitpunktes des Nulldurchgangs des Strangstroms als Zeitpunkt des Wegfallens der Diodenspannung über der Freilaufdiode des deaktivierten Leistungsschalters hat den Vorteil, dass auf zusätzliche Detektoren zur Messung des Strangstroms verzichtet werden kann. Die Ermittlung des Zeitpunkts des Nulldurchgangs des Strangstroms basiert lediglich auf der ohnehin erforderlichen Messung der Anschlussspannungen an den Anschlussknoten für die Phasenstränge der elektrischen Maschine.

Weiterhin kann das Deaktivieren der pulsweitenmodulierten Ansteuerung für mindestens einen der Leistungsschalter innerhalb eines Messzeitfensters durchgeführt werden, das zu einem Zeitpunkt beginnt, der von einem Zeitpunkt eines Vorzeichenwechsels der Phasenspannung abhängt oder diesem entspricht, und frühestens zu einem Zeitpunkt endet, an dem der Nulldurchgang des Strangstromes festgestellt worden ist. Insbesondere kann der Schritt des Deaktivierens der pulsweitenmodulierten Ansteuerung umfassen, dass nur derjenige Leistungsschalter deaktiviert wird, durch den der momentane Strangstrom einen Diodenstrom in Vorwärtsrichtung bewirkt.

Gemäß einer Ausführungsform kann derjenige Leistungsschalter, durch den der momentane Strangstrom einen Diodenstrom in Vorwärtsrichtung bewirkt, durch den Gradienten des Verlaufs der Phasenspannung bestimmt werden.

Ferner kann das Tastverhältnis zwischen 30% und 70% liegen.

Gemäß einem weiteren Aspekt ist ein Verfahren zum Bestimmen einer Läuferlage eines Läufers einer elektrischen Maschine vorgesehen. Das Verfahren umfasst die folgenden Schritte:
- Ermitteln eines Zeitpunkts des Nulldurchgangs eines Strangstroms mit Hilfe des obigen Verfahrens;
- nach dem Feststellen des Zeitpunkts des Nulldurchgangs des Strangstroms, Bestimmen einer Höhe mindestens einer induzierten Spannung über dem Phasenstrang innerhalb eines weiteren Messzeitfensters, während die dem Phasenstrang zugeordneten Leistungsschalter der elektrischen Maschine nichtleitend geschaltet sind;
- Ermitteln der Läuferlage aus der mindestens einen induzierten Spannung.

Gemäß einem weiteren Aspekt ist eine Vorrichtung zum Ermitteln eines Zeitpunkts eines Nulldurchgangs eines Strangstroms in einer mehrphasigen elektrischen Maschine vorgesehen, die mit Hilfe einer Treiberschaltung mit Leistungsschaltern angesteuert wird, indem mehrere Phasenspannungen bereitgestellt werden, wobei die Phasenspannungen an entsprechenden Phasen zugeordnete Anschlussknoten der elektrischen Maschine angelegt werden, wobei zumindest ein Teil der Leistungsschalter gemäß einer Pulsweitenmodulation mit einem Tastverhältnis zyklisch ansteuerbar ist, um zum Bereitstellen der jeweiligen Phasenspannung an einen der Anschlussknoten verschiedene Potenziale im Wechsel anzulegen. Die Vorrichtung ist ausgebildet,
- um die Treiberschaltung zum Bereitstellen von mehreren Phasenspannungen anzusteuern, um die elektrische Maschine zu betreiben;
- um die pulsweitenmodulierte Ansteuerung für mindestens einen der Leistungsschalter zu deaktivieren, so dass zumindest während eines Zeitabschnitts in jedem Zyklus der Pulsweitenmodulation kein Potenzial durch die Treiberschaltung an den Anschlussknoten angelegt wird;
- um innerhalb des Zeitabschnitts eine Diodenspannung über einer Freilaufdiode zu detektieren, mit der mindestens eine deaktivierte Leistungsschalter versehen ist; und
- um den Zeitpunkt des Nulldurchgangs des Strangstroms als den Zeitpunkt festzustellen, ab dem innerhalb des Zeitabschnitts keine Diodenspannung über der Freilaufdiode mehr vorliegt.

Gemäß einem weiteren Aspekt ist ein Motorsystem vorgesehen. Das Motorsystem umfasst:
- eine mehrphasige elektrische Maschine;
- eine Treiberschaltung, die Inverterschaltungen mit jeweils einer seriellen Verschaltung zwischen einem ersten Potenzial und einem zweiten Potenzial angeschlossenen Leistungsschaltern aufweist;
- die obige Vorrichtung.

Gemäß einem weiteren Aspekt ist ein Computerprogrammprodukt vorgesehen, das einen Programmcode enthält, der, wenn er auf einer Datenverarbeitungseinheit ausgeführt wird, das obige Verfahren durchführt.

### Kurzbeschreibung der Zeichnungen

Bevorzugte Ausführungsformen werden nachfolgend anhand der beigefügten Zeichnungen näher erläutert. Es zeigen:
- Figur 1: eine schematische Darstellung eines Motorsystems zum Betreiben einer elektrischen Maschine;
- Figur 2: ein Schaltbild einer Treiberschaltung in einer 2H-Topologie zum Ansteuern einer zweiphasigen elektrischen Maschine;
- Figur 3: eine schematische Darstellung der Verläufe eines Strangstroms durch einen Phasenstrang, einer in dem Phasenstrang induzierten Spannung und der angelegten Phasenspannung, sowie die entsprechenden Schaltsignale für die Leistungsschalter einer der H-Brücken zum Betreiben eines Phasenstranges;
- Figur 4: eine detailliertere Darstellung der Verläufe des Strangstroms durch den Phasenstrang, der induzierten Spannung und der Phasenspannung, der Ansteuersignale für die Leistungsschalter sowie der resultierenden Anschlussspannungen in einem Bereich des Nulldurchgangs des Strangstroms;
- Figur 5: ein Schaltbild einer B6-Treiberschaltung zur Ansteuerung einer dreiphasigen elektrischen Maschine;
- Figur 6: eine Darstellung der Verläufe der Phasenströme sowie der dazugehörigen Ansteuersignale der Leistungsschalter; und
- Figur 7: eine detailliertere Darstellung des Verlaufes eines der Phasenströme durch einen der Phasenstränge, die entsprechende Ansteuerung der zugehörigen Leistungsschalter und des resultierenden Anschlusspotenzials.

### Beschreibung von Ausführungsformen

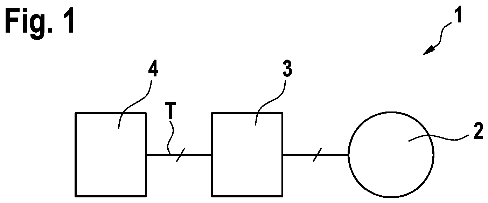

Figur 1 zeigt eine schematische Darstellung eines Motorsystems 1 mit einer elektrischen Maschine 2. Die elektrische Maschine 2 kann als elektronisch kommutierte Synchronmaschine, Asynchronmaschine oder dergleichen ausgebildet sein. Die elektrische Maschine 2 weist eine Phasenwicklung mit in der Regel mehreren Phasensträngen auf, die separat durch Anlegen einer jeweiligen Phasenspannung bestromt werden können. Gängige Synchronmaschinen sind beispielsweise zwei- oder dreiphasig. Die dazu benötigten Phasenspannungen werden mit Hilfe einer Treiberschaltung 3 bereitgestellt.

Die Treiberschaltung 3 erzeugt die Phasenspannungen abhängig von Ansteuersignalen T, die von einer Steuereinheit 4 abhängig von einer Läuferlage der elektrischen Maschine 2 erzeugt werden. Die Läuferlage der elektrischen Maschine 2 entspricht der momentanen Lage eines Läufers der elektrischen Maschine 2 und wird bei rotatorischen Maschinen als Lagewinkel angegeben.

Der Lagewinkel zur Ansteuerung der elektrischen Maschine 2 wird im vorliegenden Fall sensorlos gemäß dem Back-EMF-Verfahren durch Überwachen des Strangstroms und durch Auswerten einer Höhe und eines Verlaufes einer induzierten Spannung innerhalb eines Zeitfensters, während dessen der Phasenstrang stromlos ist, bestimmt.

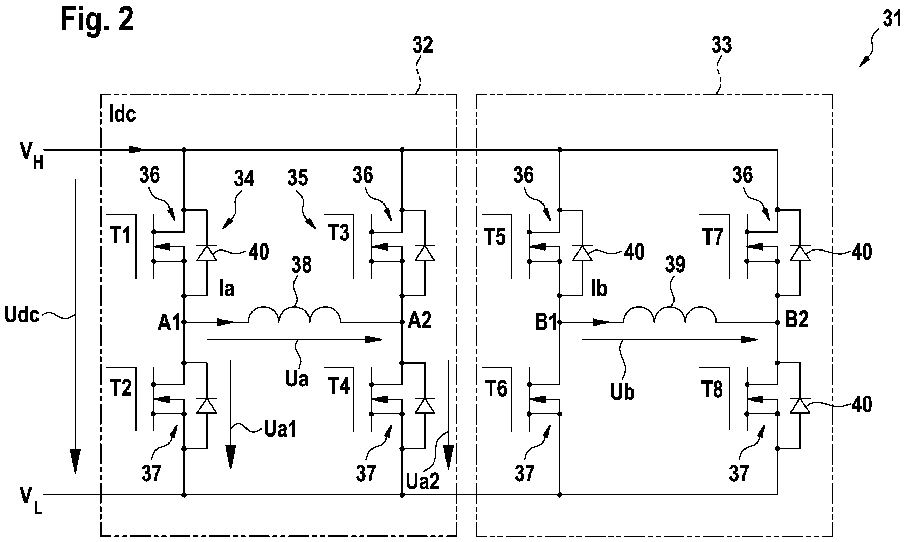

In einem ersten Ausführungsbeispiel wird von einem Motorsystem 1 ausgegangen, bei dem die Treiberschaltung 3 in Form einer 2H-Brückenschaltung ausgebildet ist, um eine zweiphasige elektrische Maschine mit zwei Phasensträngen zu betreiben. Eine derartige Topologie ist in Figur 2 dargestellt.

Die 2H-Brückenschaltung 31, die in Figur 2 dargestellt ist, weist zwei H-Brücken 32, 33 auf, die jeweils zwei Inverterschaltungen 34, 35 umfassen. Jede der Inverterschaltungen 34, 35 weist einen ersten Leistungsschalter 36 in Form eines Leistungstransistors und einen zweiten Leistungsschalter 37 in Form eines zweiten Leistungstransistors auf. Die Leistungstransistoren können als MOSFETs, Thyristoren, IGBTs, IGCTs und dergleichen ausgebildet sein. Die Leistungsschalter 36, 37 sind jeweils zwischen einem hohen Versorgungspotenzial V_{H} und einem niedrigen Versorgungspotenzial V_{L} seriell verschaltet. Ein jeweiliger Anschlussknoten A1, A2, B1, B2 zwischen den ersten und zweiten Leistungsschaltern 36, 37 ist mit einem der Phasenstränge 38, 39 der elektrischen Maschine 2 verbunden. Insbesondere ist der Anschlussknoten A1 der ersten Inverterschaltung 34 der ersten H-Brücke 32 mit einem ersten Anschluss eines ersten Phasenstranges 38 und der Anschlussknoten A2 der zweiten Inverterschaltung 35 der ersten H-Brücke 32 mit einem zweiten Anschluss des ersten Phasenstranges 38 verbunden. Die Inverterschaltungen 36, 37 der zweiten H-Brücke 33 sind in analoger Weise mit einem zweiten Phasenstrang 39 verbunden.

Die Steuereinheit 4 stellt Ansteuersignale T1 - T8 zum Ansteuern der einzelnen Leistungstransistoren 36, 37 der Inverterschaltungen 34, 35 der H-Brücken 32, 33 zur Verfügung. Durch die Ansteuersignale werden die Leistungstransistoren als Schalter betrieben, die leitend bzw. nicht-leitend geschaltet werden können.

Parallel zu den Leistungsschaltern 36, 37 sind Freilaufdioden 40 vorgesehen, die in Sperrrichtung zu der anliegenden Versorgungsspannung Udc zwischen dem hohen Versorgungspotenzial V_{H} und dem niedrigen Versorgungspotenzial V_{L} geschaltet sind. Die Freilaufdioden 40 können intrinsisch mit dem jeweiligen Leistungsschalter 36, 37 oder separat ausgebildet sein.

Zum Bewirken eines positiven Phasenstroms in dem ersten Phasenstrang 38 (Stromrichtung von links nach rechts, wie durch den Pfeil angegeben) kann eine positive Phasenspannung durch eine Ansteuerung der Leistungstransistoren 36 und 37 der ersten H-Brücke 32 gemäß einer geeigneten Pulsweitenmodulation bereitgestellt werden. Gleichzeitig wird der zweite Leistungsschalter 37 der zweiten Inverterschaltung 35 der ersten H-Brücke 32 leitend und der erste Leistungsschalter 36 der zweiten Inverterschaltung 35 der ersten H-Brücke 32 nicht-leitend geschaltet.

Soll eine negative Phasenspannung angelegt werden, so wird eine Phasenspannung durch den ersten und den zweiten Leistungsschalter 36, 37 der zweiten Inverterschaltung 35 der ersten H-Brücke 32 gemäß einer geeigneten Pulsweitenmodulation angelegt. Entsprechend wird der zweite Leistungsschalter 37 der ersten Inverterschaltung 34 der ersten H-Brücke 32 leitend und der erste Leistungsschalter 36 der ersten Inverterschaltung 34 der ersten H-Brücke 32 nicht-leitend geschaltet.

Die Ansteuerungen zum Einstellen einer positiven oder negativen Phasenspannung an dem zweiten Phasenstrang 39 sind analog.

Die Pulsweitenmodulation stellt eine zyklische Ansteuerung dar. Die durch Pulsweitenmodulation eingestellte Phasenspannung kann durch die Wahl eines Tastverhältnisses eingestellt werden. Das Tastverhältnis gibt ein Verhältnis einer Zeitdauer an, während der das hohe Versorgungspotenzial V_{H} angelegt ist, zu einer Gesamtzeitdauer, die der Zykluszeit der Pulsweitenmodulation entspricht.

Im Folgenden wird das Verfahren zum Detektieren eines Zeitpunkts des Nulldurchgangs eines der Motorströme Ia, Ib nur anhand der ersten H-Brücke 32 erläutert. Zur Bestimmung der Läuferlage wird in der Regel dieses Verfahren für beide H-Brücken ausgeführt. Zum Detektieren des Zeitpunkts des Nulldurchgangs des Strangstroms la wird die Betriebsart während eines vorgegebenen Messzeitfensters geändert. Während die getaktete Inverterschaltung 34, 35, die gemäß der Pulsweitenmodulation betrieben wird, im Normalbetrieb ein wechselweises Leitend-Schalten des ersten und zweiten Leistungsschalters 36, 37 und ein entsprechendes Nicht-leitend-Schalten vorsieht, wird in dem Messzeitfenster einer der Leistungsschalter 36, 37 der gemäß der Pulsweitenmodulation betriebenen, d.h. getakteten, Inverterschaltung permanent nicht-leitend geschaltet, so dass dieser von der Taktung durch die Pulsweitenmodulation ausgenommen ist. Im gezeigten Ausführungsbeispiel, wenn die Phasenspannung positiv ist und der Strangstrom positiv und fallend ist, wird der zweite Leistungsschalter 37 der ersten Inverterschaltung 34 nicht-leitend geschaltet und die durch die Pulsweitenmodulation vorgegebene Taktung lediglich mit dem ersten Leistungsschalter 36 fortgesetzt. Mit anderen Worten wird während des Messzeitfensters derjenige der Leistungsschalter 36, 37 der gemäß der Pulsweitenmodulation betriebenen Inverterschaltung 34, 35 nicht-leitend geschaltet, so dass der Strangstrom durch die dem Leistungsschalter zugeordnete Freilaufdiode 40 einen Diodenstrom in Vorwärtsrichtung (Durchlassrichtung) und dadurch eine Diodenspannung bewirkt.

Das Messzeitfenster ist vorzugsweise so gewählt, dass darin der Nulldurchgang des Strangstroms erwartet werden kann. Da der Verlauf des Strangstroms in der Regel zum Verlauf der Phasenspannung im betreffenden Phasenstrang nacheilend ist, ist es ausreichend, den Beginn des Messzeitfensters zum Nulldurchgang der Phasenspannung oder kurz davor festzulegen. Dies ist in einfacher Weise möglich, da die Verläufe der anzulegenden Phasenspannungen in der Steuereinheit bekannt sind. Auch werden die Ansteuersignale T1 bis T8 aus den Phasenspannungen bestimmt.

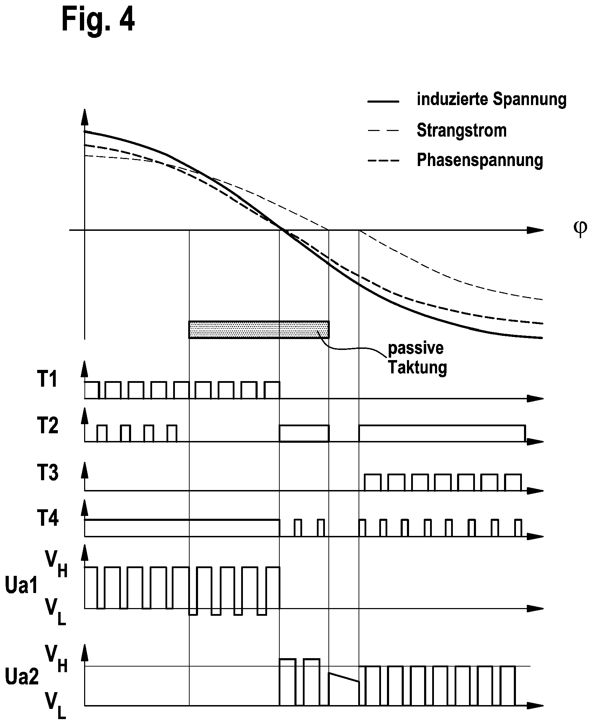

Aufgrund der induktiven Last des jeweiligen Phasenstranges 38, 39 und aufgrund der Induktion einer induzierten Spannung durch eine Bewegung des Läufers fließt z.B. in dem Fall eines Deaktivierens, d.h. des Nicht-Ieitend-Schaltens (Sperrens) des zweiten Leistungsschalters 37 während des Messzeitfensters der Strangstrom weiter. In den Zeitperioden innerhalb des Messzeitfensters, während denen aufgrund der pulsweitenmodulierten Ansteuerung des ersten Leistungsschalters 36 der erste Leistungsschalter 36 gesperrt ist (Zeitfenster in jedem Zyklus der Pulsweitenmodulation vom Ausschalten des ersten Leistungsschalters 36 bis zum Einschalten des ersten Leistungsschalters 36 im nächsten Zyklus), fließt der Strangstrom durch die Freilaufdiode 40 des zweiten Leistungsschalters 37. Die entsprechende Freilaufdiode 40 wird in diesem Fall durch den Strangstrom in Vorwärtsrichtung betrieben und führt zu einem Spannungsabfall zwischen dem niedrigen Versorgungspotenzial V_{L} und dem betreffenden Anschlussknoten A1, A2 für den ersten Phasenstrang 38. Der Strangstrom fließt durch die Freilaufdiode 40 des zweiten Leistungsschalters 37, solange der Strangstrom von dem Anschlussknoten A1 bzw. A2 in den ersten Phasenstrang 38 fließt und der zweite Leistungsschalter 37 gesperrt ist. Dies ist in der detaillierteren Darstellung der Strom- und Spannungsverläufe sowie der Signalverläufe zur Ansteuerung der ersten und zweiten Leistungsschalter 36, 37 in Figur 4 erkennbar. Man erkennt diesbezüglich, dass an dem ersten Anschlussknoten A1 während des Messzeitfensters ein unter dem Niveau des niedrigen Versorgungspotenzials liegendes Potenzial UA1 vorliegt, während die Ansteuerung mit einer positiven Phasenspannung erfolgt.

Dies gilt analog auch für den Fall eines Deaktivierens, d.h. des Nicht-leitend-Schaltens des ersten Leistungsschalters 36 bei gleichzeitigem Weiterbetreiben des zweiten Leistungsschalters 37, wobei in diesem Fall die entsprechende Freilaufdiode 40 parallel zu dem ersten Leistungsschalter 36 durch den Diodenstrom in Vorwärtsrichtung betrieben wird und zu einem Spannungsabfall zwischen dem betreffenden Anschlussknoten A1, A2 und dem hohen Versorgungspotenzial V_{H} führt. Der Diodenstrom fließt durch die Freilaufdiode 40 des ersten Leistungsschalters 36, solange der Strangstrom aus dem ersten Phasenstrang 38 zu dem Anschlussknoten A1 bzw. A2 fließt und der erste Leistungsschalter 36 permanent gesperrt ist.

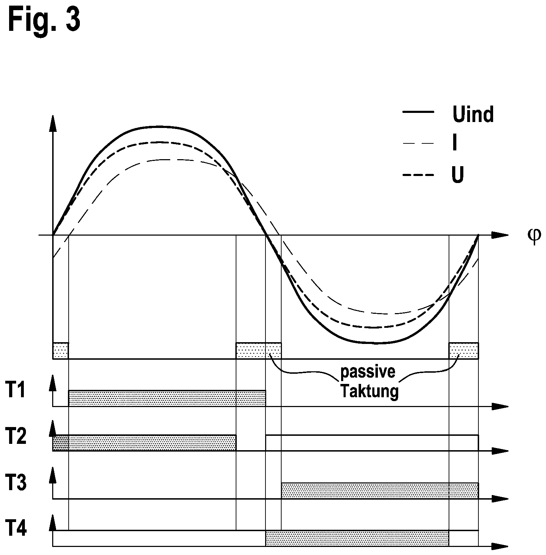

Bei der 2H-Brückenschaltung wird, wie in Figur 3 gezeigt ist, jeweils nur eine der Inverterschaltungen jeder H-Brücke gemäß einer Pulsweitenmodulation betrieben und die Leistungsschalter der jeweils anderen Inverterschaltung so geschaltet, dass der erforderliche Strangstrom aus einem der Versorgungspotenziale bereitgestellt werden kann. D.h., fließt ein Strangstrom in die jeweils nicht gemäß der Pulsweitenmodulation angesteuerte Inverterschaltung hinein, so wird der zweite Leistungsschalter 37 leitend und der erste Leistungsschalter 37 nicht-leitend geschaltet und umgekehrt.

Erreicht in einer Phase die durch die Ansteuersignale zu bewirkende Phasenspannung einen Nulldurchgang, so geht bei der 2H-Brückenschaltung die pulsweitenmodulierte Ansteuerung auf die entsprechend andere Inverterschaltung der der betreffenden Phase zugeordneten H-Brücke über und die Leistungsschalter 36, 37 der jeweils anderen Inverterschaltung 34, 35 werden, wie oben beschrieben, so geschaltet, dass der erforderliche Strangstrom aus einem der Versorgungspotenziale V_{L}, V_{H} bereitgestellt werden kann.

Nachdem in dem in Figur 4 gezeigten Beispiel eine negative Spannung als Phasenspannung angelegt wird, erfolgt die Pulsweitenmodulation durch die zweite Inverterschaltung 35. Um dort zur Detektion des Strangstroms bei dem noch positiven Strangstrom la, einen Spannungsabfall über einer vorwärtsbetriebenen Freilaufdiode 40 eines der Leistungsschalter 36, 37 zu erreichen, muss nun während des Messzeitfensters der erste Leistungsschalter 36 der zweiten Inverterschaltung 35 deaktiviert bleiben und die Pulsweitenmodulation lediglich mit Hilfe des zweiten Leistungsschalters 37 der zweiten Inverterschaltung 35 durchgeführt werden. Dies erfolgt bei gesperrtem ersten Leistungsschalter 36 und leitendem zweiten Leistungsschalter 37 der ersten nicht getakteten Inverterschaltung.

Während des Messzeitfensters wird, solange und wenn die an den Phasenstrang angelegte Phasenspannung positiv ist, das Potenzial am ersten Anschlussknoten A1 überwacht. Es kann in den Ansteuerpausen der zyklischen Ansteuerung des ersten Leistungsschalters 36 der getakteten Inverterschaltung, d.h. wenn gemäß dem Tastverhältnis der erste Leistungsschalter 36 nicht-leitend geschaltet ist, festgestellt werden, ob sich aufgrund der leitenden Freilaufdiode parallel zum zweiten Leistungsschalter 37 der ersten Inverterschaltung 34 eine Diodenspannung addiert hat. Dies zeigt sich am ersten Anschlussknoten A1 dadurch, dass eine im Vergleich zu dem niedrigen Versorgungspotenzial V_{L} negativere Spannung über dem zweiten Leistungsschalter 37 der ersten Inverterschaltung 34 anliegt.

Nach dem Umschalten der Pulsweitenmodulation auf die zweite Inverterschaltung 35 bei negativer Phasenspannung kann das Fließen eines Strangstroms durch eine Freilaufdiode des deaktivierten ersten Leistungsschalters 36 der zweiten Inverterschaltung 35 festgestellt werden, wenn das an dem zweiten Anschlussknoten A2 anliegende Spannungspotenzial das hohe Versorgungspotenzial V_{H} um eine Diodenspannung der Freilaufdiode übersteigt. Dies wird zu Beginn des Messzeitfensters der Fall sein, da ein Strangstrom in positiver Richtung fließt. Erreicht der Strangstrom jedoch den Nulldurchgang, so fließt kein Freilaufstrom mehr und der entsprechende Spannungsabfall über der entsprechenden, von der Taktung ausgenommenen Freilaufdiode tritt nicht mehr auf. Der Nulldurchgang des Strangstroms kann also gemäß oben beschriebener Vorgehensweise als der Zeitpunkt festgestellt werden, ab dem kein Abfall einer Diodenspannung über der betreffenden Freilaufdiode detektiert werden kann.

Ist der Zeitpunkt des Nulldurchgangs des Strangstroms erreicht, so werden zur Bestimmung der Läuferlage die ersten und zweiten Leistungsschalter 36, 37 der Inverterschaltungen 34, 35, die mit dem betreffenden Phasenstrang verbunden sind, während eines weiteren Messzeitfensters gesperrt und Höhe und/oder Gradient der über den Phasenstrang 38, 39 induzierten Spannung U_{ind} ermittelt.

Die Höhe der über den Phasenstrang 38, 39 induzierten Spannung U_{ind} kann durch Messung der Spannungspotenziale an dem ersten und dem zweiten Anschlussknoten A1, A2 bzw. der Spannungen über den zweiten Leistungsschaltern 37 und anschließendes Bilden einer Differenz zwischen den so erhaltenen Werten erfolgen. Der Gradient der induzierten Spannung kann durch ein zeitlich versetztes mehrfaches Messen der Spannungspotenziale bzw. der Spannungen an den Anschlussknoten A1, A2 und anschließende Differenzbildung ermittelt werden, um zwei Werte zu erhalten. Daraus und mit Hilfe des zeitlichen Abstands zwischen den Messungen innerhalb des weiteren Messzeitfensters kann in bekannter Weise der zeitliche Gradient des Verlaufs der induzierten Spannung innerhalb des weiteren Messzeitfensters ermittelt werden.

Mit Hilfe des Gradienten und der Höhe der gemessenen induzierten Spannung lässt sich näherungsweise z.B. durch lineare Regression auf den Nulldurchgang der induzierten Spannung schließen, z.B. durch Berechnung eines Nulldurchgangs einer Geraden mit einer Steigung in Höhe des gemessenen Gradienten und anhand der gemessenen Höhe der induzierten Spannung zu einem bestimmten Zeitpunkt innerhalb des weiteren Messzeitfensters. Der Zeitpunkt des Nulldurchgangs der induzierten Spannung kann als Maß für die Läuferlage verwendet werden. Wurde anhand des obigen Verfahrens der Zeitpunkt des Nulldurchgangs des Strangstroms bestimmt und die induzierte Spannung innerhalb des weiteren Messzeitfensters ermittelt, so wird die Ansteuerung der elektrischen Maschine gemäß dem Normalbetrieb wieder aufgenommen, d.h. die pulsweitenmodulierte Ansteuerung beider Leistungsschalter 36, 37 der zuletzt gemäß der Pulsweitenmodulation angesteuerten Inverterschaltung, in diesem Fall der zweiten Inverterschaltung 35, wiederaufgenommen.

Das Prinzip des oben beschriebenen Ansteuerverfahrens sieht vor, bei einer mehrphasigen elektronisch kommutierten elektrischen Maschine, die mit Hilfe von pulsweitenmodulierten Phasenspannungen betrieben wird, in einem Messzeitfenster, in dem ein Nulldurchgang des Strangstroms erwartet wird, einen der Leistungsschalter 36, 37 der getakteten Inverterschaltung auszunehmen und für die Dauer des Messzeitfensters vollständig zu sperren. Der gesperrte Leistungsschalter der getakteten Inverterschaltung entspricht demjenigen Leistungsschalter, an dem ein Diodenstrom in Vorwärtsrichtung aufgrund des entsprechenden Strangstroms auftritt.

Erreicht der Strangstrom dann den Nulldurchgang, wird auch der Freilaufstrom zu Null und es fällt keine Diodenspannung über die entsprechende Freilaufdiode 40 mehr ab. Stattdessen sperrt die nun herrschende Polarität die Freilaufdiode, so dass eine Spannung über der Diode abfällt, die der Spannung über dem zugeordneten Leistungsschalter entspricht. Der Zeitpunkt des Wegfalls der Diodenspannung, der durch entsprechende Überwachung und Auswertung der Anschlusspotenziale an dem ersten Anschluss A1 und an dem zweiten Anschluss A2 detektiert werden kann, kann als der Zeitpunkt des Nulldurchgangs des Strangstroms bestimmt werden.

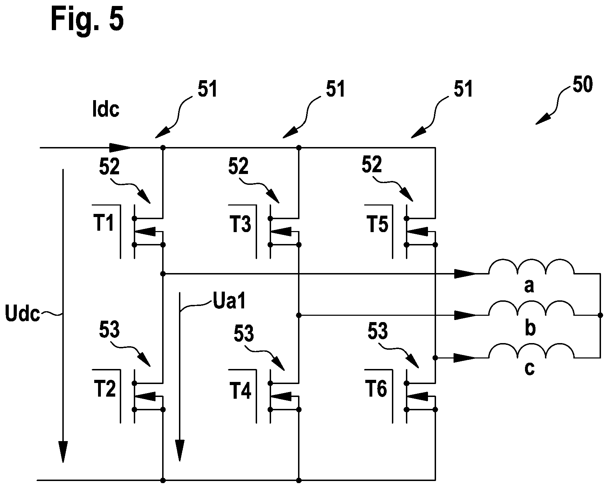

In Figur 5 ist eine B6-Brückenschaltung 50 als eine alternative Treiberschaltung für das Motorsystem 1 dargestellt. Die B6-Brückenschaltung 50 eignet sich insbesondere dafür, eine dreiphasige elektrische Maschine anzusteuern. Die B6-Brückenschaltung 50 weist drei Inverterschaltungen 51 auf, die wie zuvor jeweils einen ersten Leistungsschalter 52 und einen zweiten Leistungsschalter 53 aufweisen. Wie bei dem Ausführungsbeispiel der Figur 2 sind die einzelnen Leistungsschalter 52, 53 in Reihe geschaltet, wobei an dem Anschlussknoten A zwischen den Leistungsschaltern 52, 53 ein Phasenstrang der zu betreibenden elektrischen Maschine 2 angeschlossen wird. Die Phasenstränge sind im gezeigten Ausführungsbeispiel in Sternschaltung verschaltet, es können jedoch auch andere Arten der Verschaltung der Phasenstränge der elektrischen Maschine vorgesehen sein. Jeder der Leistungsschalter 52, 53 ist mit einer Freilaufdiode 54 versehen, die wie oben beschrieben intrinsisch oder separat ausgebildet sein kann.

Bei der B6-Brückenschaltung 50 ist jede der Inverterschaltungen 51 einer Phase d.h. einem Phasenstrang der elektrischen Maschine zugeordnet. Bei der B6-Brückenschaltung werden durch die Steuereinheit 4 die Inverterschaltungen 51 jeweils gemäß einem Ansteuermuster angesteuert, das einer Pulsweitenmodulation mit einem bestimmten Tastverhältnis entspricht. So kann durch Wahl der einzelnen Phasenspannungen der gewünschte Spannungszeiger an die elektrische Maschine 2 angelegt werden. Grundsätzlich gilt, dass zum Feststellen des Zeitpunktes des Nulldurchgangs eines Strangstroms einer Phase die der Phase zugeordnete Inverterschaltung 51 während des Messzeitfensters gemäß der passiven Taktung betrieben wird. Das Messzeitfenster wird so gewählt, dass es sicher vor dem Erreichen des Nulldurchgangs des betreffenden Strangstromes beginnt, z.B. zum Zeitpunkt eines Nulldurchgangs der betreffenden Phasenspannung oder vor diesem Zeitpunkt, und frühestens mit dem Erkennen des Zeitpunkts des Nulldurchgangs des Strangstroms endet.

Ist der Strangstrom zum Zeitpunkt des Beginns des Messzeitfensters positiv (d.h. der Strom fließt von der betreffenden Inverterschaltung in die elektrische Maschine), wird für die passive Taktung der betreffende zweite Leistungsschalter 53 nicht-leitend geschaltet, während der erste Leistungsschalter 52 mit dem entsprechenden pulsweitenmodulierten Ansteuersignal weiter betrieben wird. Ist der Strangstrom zum Zeitpunkt des Beginns des Messzeitfensters negativ, wird stattdessen der erste Leistungsschalter 52 gesperrt, während der zweite Leistungsschalter 53 entsprechend getaktet wird. Im letztgenannten Fall ist das Ansteuersignal für den zweiten Leistungsschalter 53 weiterhin das Signal, das im Normalbetrieb (also außerhalb der passiven Taktung) ein Durchschalten des zweiten Leistungsschalters 53 bewirkt, während der erste Leistungsschalter 52 ausgeschaltet wäre.

Derjenige Leistungsschalter 52, 53, durch den der momentane Strangstrom einen Diodenstrom in Vorwärtsrichtung bewirkt, kann beispielsweise durch den Gradienten des Verlaufs der vorgegebenen Phasenspannung bestimmt werden. Ist der Gradient positiv, so erfolgt ein Nulldurchgang der Phasenspannung in Richtung positiver Werte, was - nacheilend - einen Nulldurchgang des Strangstromes von negativem Strangstrom zu einem positiven Strangstrom bewirkt. D.h. zu Beginn des Messzeitfensters ist der Strangstrom negativ und fließt von dem Phasenstrang in den betreffenden Anschlussknoten hinein. In diesem Fall könnte nur die Freilaufdiode des ersten Leistungsschalters 52 in Vorwärtsrichtung betrieben werden. Daher wird die Taktung des ersten Leistungsschalters 52 während des Messzeitfensters deaktiviert. Ist der Gradient negativ, so erfolgt ein Nulldurchgang der Phasenspannung in Richtung negativer Werte, was - nacheilend - einen Nulldurchgang des Strangstromes von einem positiven Strangstrom zu einem negativen Strangstrom bewirkt. D.h. zu Beginn des Messzeitfensters ist der Strangstrom positiv und fließt von den betreffenden Anschlussknoten in den Phasenstrang hinein. In diesem Fall könnte nur die Freilaufdiode des zweiten Leistungsschalters 53 in Vorwärtsrichtung betrieben werden. Daher wird die Taktung des zweiten Leistungsschalters 53 während des Messzeitfensters deaktiviert.

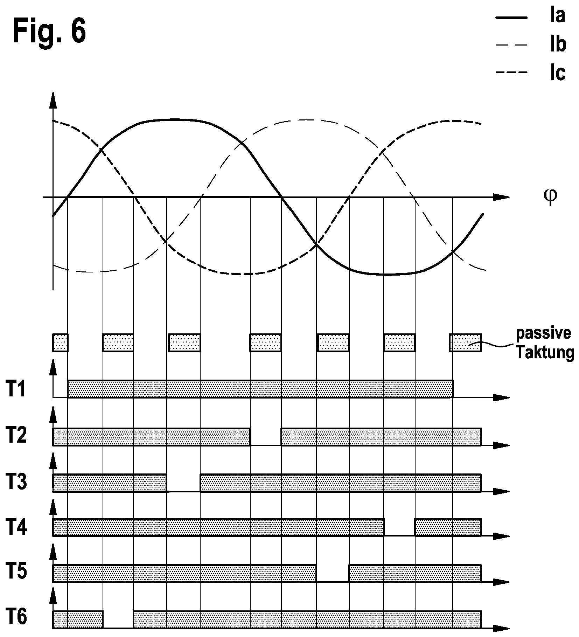

Figur 6 zeigt die Verläufe der Strangströme la, lb, lc und die entsprechenden Signalverläufe der Ansteuersignale T1 bis T6 für die Leistungsschalter 52, 53 sowie die einzelnen Zeitfenster für die passive Taktung während derer das entsprechende Ansteuersignal für jeweils einen der Leistungsschalter 52, 53 zum Nicht-leitend-Schalten (Sperren) des betreffenden Leistungsschalters 52, 53 geschaltet wird.

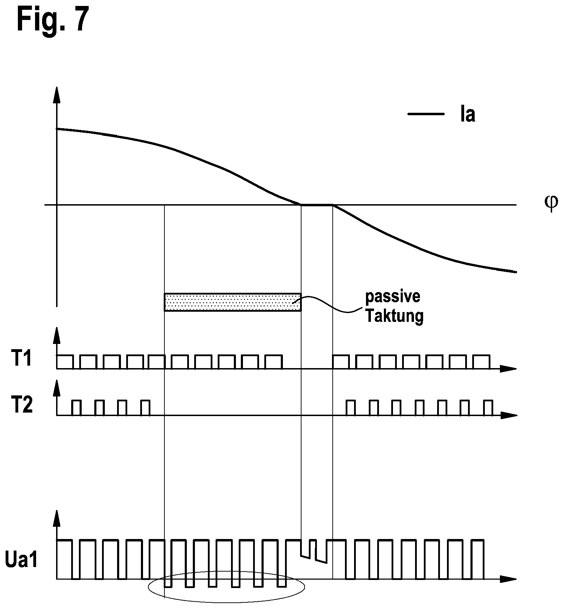

Fig. 7 illustriert analog zu oben beschriebener Ausführungsform die passive Taktung für eine der Inverterschaltungen 51 der B6-Schaltung. Analog zu dem zuvor beschriebenen Fall wird auch hier der Zeitpunkt des Nulldurchgangs des betreffenden Strangstroms als der Zeitpunkt festgestellt, wenn der Strangstrom keine Diodenspannung über der Freilaufdiode 54 des deaktivierten Leistungsschalters 52, 53 mehr bewirkt.

Wie zuvor beschrieben kann, wenn der Zeitpunkt des Nulldurchgangs des betreffenden Strangstroms festgestellt worden ist, durch Messung einer Höhe und eines Gradienten einer induzierten Spannung an dem entsprechenden Phasenstrang innerhalb eines sich unmittelbar an den Zeitpunkt des Nulldurchgangs des Strangstroms anschließenden weiteren Messzeitfensters auf eine Läuferlage mit Hilfe bekannter Verfahren geschlossen werden.

## Patentansprüche

1. Verfahren zum Ermitteln eines Zeitpunkts eines Nulldurchgangs eines Strangstroms in einer mehrphasigen elektrischen Maschine (2), wobei die elektrische Maschine (2) mit Hilfe einer Treiberschaltung (31; 50) mit Leistungsschaltern (36, 37; 52, 53) angesteuert wird, um mehrere Phasenspannungen bereitzustellen, die an entsprechenden Phasen zugeordnete Anschlussknoten (A1, A2, B1, B2) der elektrischen Maschine (2) angelegt werden, wobei die Leistungsschalter (36, 37; 52, 53) jeweils zwischen einem hohen Versorgungspotenzial (V_{H}) und einem niedrigen Versorgungspotenzial (V_{L}) seriell verschaltet sind, wobei der jeweilige Anschlussknoten (A1, A2, B1, B2) zwischen den Leistungsschaltern (36, 37; 52, 53) vorgesehen ist, wobei zumindest ein Teil der Leistungsschalter (36, 37; 52, 53) gemäß einer Pulsweitenmodulation mit einem Tastverhältnis zyklisch ansteuerbar ist, um an einen der Anschlussknoten (A1, A2, B1, B2) verschiedene Potenziale im Wechsel anzulegen, mit folgenden Schritten:
- Ansteuern der Treiberschaltung (31; 50) zum Bereitstellen der Phasenspannungen, um die elektrische Maschine (2) zu betreiben;
- Deaktivieren der pulsweitenmodulierten Ansteuerung für mindestens einen der Leistungsschalter (36, 37; 52, 53), so dass der mindestens eine Leistungsschalter (36, 37; 52, 53) permanent nicht-leitend geschaltet wird und dieser von der Taktung durch die Pulsweitenmodulation ausgenommen ist und zumindest während eines Zeitabschnitts in jedem Zyklus der Pulsweitenmodulation kein Potenzial durch die Treiberschaltung (31; 50) an den Anschlussknoten (A1, A2, B1, B2) angelegt wird, wobei der Zyklus durch eine zyklische Ansteuerung der Pulsweitenmodulation bestimmt ist;
- Detektieren einer Diodenspannung über einer Freilaufdiode, mit der der deaktivierte Leistungsschalter (36, 37; 52, 53) versehen ist, innerhalb des Zeitabschnitts;
- Feststellen des Zeitpunkts des Nulldurchgangs des Strangstroms als der Zeitpunkt, ab dem innerhalb des Zeitabschnitts keine Diodenspannung über der Freilaufdiode (40; 54) mehr vorliegt, wobei die Diodenspannung durch einen Diodenstrom in Vorwärtsrichtung bewirkt wird;
**dadurch gekennzeichnet, dass** das Deaktivieren der pulsweitenmodulierten Ansteuerung für mindestens einen der Leistungsschalter (36, 37; 52, 53) innerhalb eines Messzeitfensters durchgeführt wird, wobei nur derjenige Leistungsschalter (36, 37; 52, 53) deaktiviert wird, durch den der momentane Strangstrom einen Diodenstrom in Vorwärtsrichtung bewirkt.

2. Verfahren nach Anspruch 1, wobei das Messzeitfenster zu einem Zeitpunkt beginnt, der von einem Zeitpunkt eines Vorzeichenwechsels der Phasenspannung abhängt oder diesem entspricht, und frühestens zu einem Zeitpunkt endet, an dem der Nulldurchgang des Strangstromes festgestellt worden ist.

3. Verfahren nach Anspruch 2, wobei derjenige Leistungsschalter (36, 37; 52, 53), durch den der momentane Strangstrom einen Diodenstrom in Vorwärtsrichtung bewirkt, durch den Gradienten des Verlaufs der Phasenspannung bestimmt wird.

4. Verfahren nach einem der Ansprüche 1 bis 3, wobei das Tastverhältnis zwischen 30% und 70% liegt.

5. Verfahren zum Bestimmen einer Läuferlage eines Läufers einer elektrischen Maschine (2), mit folgenden Schritten:
- Ermitteln eines Zeitpunkts des Nulldurchgangs eines Strangstroms mit Hilfe eines Verfahrens gemäß einem der Ansprüche 1 bis 4;
- nach dem Feststellen des Zeitpunkts des Nulldurchgangs des Strangstroms, Bestimmen einer oder mehrerer induzierten Spannungen über dem Phasenstrang (38, 39) innerhalb eines weiteren Messzeitfensters, während die dem Phasenstrang zugeordneten Leistungsschalter der elektrischen Maschine nicht-leitend geschaltet sind;
- Ermitteln der Läuferlage aus der mindestens einen induzierten Spannung, indem zur Bestimmung der Läuferlage die einem bestimmten Phasenstrang zugeordneten Leistungsschalter (36, 37; 52, 53) während eines weiteren Messzeitfensters gesperrt und Höhe und/oder Gradient der über den Phasenstrang (38, 39) induzierten Spannung U_{ind} ermittelt werden und indem aus dem Gradienten und der Höhe der gemessenen induzierten Spannung der Nulldurchgang der induzierten Spannung ermittelt wird, wobei ein Zeitpunkt des Nulldurchgangs der induzierten Spannung ein Maß für die Läuferlage darstellt.

6. Vorrichtung zum Ermitteln eines Zeitpunkts eines Nulldurchgangs eines Strangstroms in einer mehrphasigen elektrischen Maschine (2), die mit Hilfe einer Treiberschaltung (3; 31; 50) mit Leistungsschaltern (36, 37; 52, 53) angesteuert wird, indem mehrere Phasenspannungen bereitgestellt werden, die an entsprechenden Phasen zugeordnete Anschlussknoten der elektrischen Maschine (2) angelegt werden, wobei die Leistungsschalter (36, 37; 52, 53) jeweils zwischen einem hohen Versorgungspotenzial (V_{H}) und einem niedrigen Versorgungspotenzial (V_{L}) seriell verschaltet sind, wobei der jeweilige Anschlussknoten (A1, A2, B1, B2) zwischen den Leistungsschaltern (36, 37; 52, 53) vorgesehen ist, wobei zumindest ein Teil der Leistungsschalter gemäß einer Pulsweitenmodulation mit einem Tastverhältnis zyklisch ansteuerbar ist, um zum Bereitstellen der jeweiligen Phasenspannung an einen der Anschlussknoten verschiedene Potenziale im Wechsel anzulegen,
wobei die Vorrichtung ausgebildet ist,
- zum Ansteuern der Treiberschaltung (3; 31; 50) zum Bereitstellen von mehreren Phasenspannungen, um die elektrische Maschine (2) zu betreiben;
- um die pulsweitenmodulierte Ansteuerung für mindestens einen der Leistungsschalter (36, 37; 52, 53) zu deaktivieren, so dass der mindestens eine Leistungsschalter (36, 37; 52, 53) permanent nichtleitend geschaltet wird und dieser von der Taktung durch die Pulsweitenmodulation ausgenommen ist und zumindest während eines Zeitabschnitts in jedem Zyklus der Pulsweitenmodulation kein Potenzial durch die Treiberschaltung (3; 31; 50) an den Anschlussknoten (A1, A2, B1, B2) angelegt wird, wobei der Zyklus durch eine zyklische Ansteuerung der Pulsweitenmodulation bestimmt ist;
- um innerhalb des Zeitabschnitts eine Diodenspannung über einer Freilaufdiode (40; 54) zu detektieren, mit der der mindestens eine deaktivierte Leistungsschalter (36, 37; 52, 53) versehen ist, wobei die Diodenspannung durch einen Diodenstrom in Vorwärtsrichtung bewirkt wird;
um den Zeitpunkt des Nulldurchgangs des Strangstroms als den Zeitpunkt festzustellen, ab dem innerhalb des Zeitabschnitts keine Diodenspannung über der Freilaufdiode (40; 54) mehr vorliegt,
**dadurch gekennzeichnet, dass**
die Vorrichtung ausgebildet ist, um das Deaktivieren der pulsweitenmodulierten Ansteuerung für mindestens einen der Leistungsschalter (36, 37; 52, 53) innerhalb eines Messzeitfensters durchzuführen, wobei nur derjenige Leistungsschalter (36, 37; 52, 53) deaktiviert wird, durch den der momentane Strangstrom einen Diodenstrom in Vorwärtsrichtung bewirkt.

7. Motorsystem (1), umfassend:
- eine mehrphasige elektrische Maschine (2);
- eine Treiberschaltung (3), die Inverterschaltungen (34, 35, 51) mit jeweils einer seriellen Verschaltung zwischen einem ersten Potenzial und einem zweiten Potenzial angeschlossenen Leistungsschaltern (36, 37; 52, 53) aufweist;
- eine Vorrichtung nach Anspruch 6.

8. Computerprogrammprodukt, das einen Programmcode enthält, der ausgebildet ist, um bei Ausführung auf einer Datenverarbeitungseinheit das Verfahren nach einem der Ansprüche 1 bis 6 durchzuführen.

## Claims

1. Method for determining a time of a zero crossing of a winding phase current in a polyphase electric machine (2), the electric machine (2) being actuated with the aid of a driver circuit (31; 50) with power switches (36; 37; 52, 53) in order to provide a plurality of phase voltages, which are applied to connection nodes (A1, A2, B1, B2) of the electric machine (2) which are associated with corresponding phases, the power switches (36, 37; 52, 53) each being connected in series between a high supply potential (V_{H}) and a low supply potential (V_{L}), the respective connection node (A1, A2, B1, B2) being provided between the power switches (36, 37; 52, 53), at least some of the power switches (36, 37; 52, 53) being actuable cyclically on the basis of pulse width modulation with a duty factor in order to apply different potentials alternately to one of the connection nodes (A1, A2, B1, B2), said method comprising the following steps:
- actuating the driver circuit (31; 50) for providing the phase voltages in order to operate the electric machine (2);
- deactivating the pulse-width-modulated actuation for at least one of the power switches (36, 37; 52, 53), with the result that the at least one power switch (36, 37; 52, 53) is switched so as to be permanently nonconducting and said power switch is excluded from the clocking by the pulse width modulation, and, at least during a time segment in each cycle of the pulse width modulation, no potential is applied by the driver circuit (31; 50) to the connection nodes (A1, A2, B1, B2), the cycle being determined by a cyclic actuation of the pulse width modulation;
- detecting a diode voltage across a freewheeling diode, with which the deactivated power switch (36, 37; 52, 53) is provided, within the time segment;
- fixing the time of the zero crossing of the winding phase current as the time after which, within the time segment, there is no longer a diode voltage present across the freewheeling diode (40; 54), the diode voltage being effected through a diode current in the forward direction;
**characterized in that**
the deactivation of the pulse-width-modulated actuation for at least one of the power switches (36, 37; 52, 53) is performed within a measurement time window, wherein only that power switch (36, 37; 52, 53) is deactivated through which the instantaneous winding phase current effects a diode current in the forward direction.

2. Method according to Claim 1, wherein the measurement time window begins at a time which is dependent on or corresponds to a time at which the mathematical sign of the phase voltage changes and ends at the earliest at a time at which the zero crossing of the winding phase current has been fixed.

3. Method according to Claim 2, wherein that power switch (36, 37; 52, 53) through which the instantaneous winding phase current effects a diode current in the forward direction is determined by the gradient of the profile of the phase voltage.

4. Method according to one of Claims 1 to 3, wherein the duty factor is between 30% and 70%.

5. Method for determining a rotor position of a rotor of an electric machine (2), said method comprising the following steps:
- determining a time of the zero crossing of a winding phase current with the aid of a method according to one of Claims 1 to 4;
- once the time of the zero crossing of the winding phase current has been fixed, determining one or more induced voltages across the winding phase (38, 39) within a further measurement time window, while the power switches of the electric machine which are associated with the winding phase are switched so as to be nonconducting;
- determining the rotor position from the at least one induced voltage by, for the purpose of determining the rotor position, blocking the power switches (36, 37; 52, 53) associated with a particular winding phase during a further measurement time window and determining the level and/or gradient of the voltage U_{ind} induced across the winding phase (38, 39) and by determining the zero crossing of the induced voltage from the gradient and the level of the measured induced voltage, a time of the zero crossing of the induced voltage being a measure of the rotor position.

6. Apparatus for determining a time of a zero crossing of a winding phase current in a polyphase electric machine (2), which is actuated with the aid of a driver circuit (3; 31; 50) with power switches (36, 37; 52, 53) by virtue of a plurality of phase voltages being provided which are applied to connection nodes of the electric machine (2) which are associated with corresponding phases, the power switches (36, 37; 52, 53) each being connected in series between a high supply potential (V_{H}) and a low supply potential (V_{L}), the respective connection node (A1, A2, B1, B2) being provided between the power switches (36, 37; 52, 53), at least some of the power switches being actuable cyclically on the basis of pulse width modulation with a duty factor in order to apply different potentials alternately to one of the connection nodes in order to provide the respective phase voltage,
wherein the apparatus is designed
- to actuate the driver circuit (3; 31; 50) for providing a plurality of phase voltages in order to operate the electric machine (2);
- to deactivate the pulse-width-modulated actuation for at least one of the power switches (36, 37; 52, 53), with the result that the at least one power switch (36, 37; 52, 53) is switched so as to be permanently nonconducting and said power switch is excluded from the clocking by the pulse width modulation, and, at least during a time segment in each cycle of the pulse width modulation, no potential is applied to the connection nodes (A1, A2, B1, B2) by the driver circuit (3; 31; 50), the cycle being determined by a cyclic actuation of the pulse width modulation;
- to detect, within the time segment, a diode voltage across a freewheeling diode (40; 54) with which the at least one deactivated power switch (36, 37; 52, 53) is provided, the diode voltage being effected through a diode current in the forward direction;
- to fix the time of the zero crossing of the winding phase current at the time after which, within the time segment, there is no longer a diode voltage present across the freewheeling diode (40; 54),
**characterized in that**
the apparatus is designed to perform the deactivation of the pulse-width-modulated actuation for at least one of the power switches (36, 37; 52, 53) within a measurement time window, wherein only that power switch (36, 37; 52, 53) is deactivated through which the instantaneous winding phase current effects a diode current in the forward direction.

7. Motor system (1), comprising:
- a polyphase electric machine (2);
- a driver circuit (3), which has inverter circuits (34, 35, 51), each having series interconnection of power switches (36, 37; 52, 53) connected between a first potential and a second potential;
- an apparatus according to Claim 6.

8. Computer program product, which contains a program code which is configured to implement the method according to one of Claims 1 to 6 when run on a data processing unit.

## Revendications

1. Procédé pour déterminer le moment d'un passage par zéro d'un courant de phase dans une machine électrique polyphasée (2), dans lequel la machine électrique (2) est commandée à l'aide d'un circuit d'attaque (31 ; 50) comportant des disjoncteurs (36, 37 ; 52, 53) destinés à fournir plusieurs tensions de phase, qui sont appliquées à des noeuds de raccordement respectifs (A1, A2, B1, B2) associés aux phases, de la machine électrique (2), dans lequel les disjoncteurs (36, 37 ; 52, 53) sont respectivement montés en série entre un potentiel d'alimentation haut (V_{H}) et un potentiel d'alimentation bas (V_{L}), dans lequel le noeud de raccordement respectif (A1, A2, B1, B2) est prévu entre les disjoncteurs (36, 37 ; 52, 53), dans lequel au moins une partie des disjoncteurs (36, 37 ; 52, 53) peut être commandée cycliquement selon une modulation de largeur d'impulsion au moyen d'un certain rapport cyclique afin d'appliquer alternativement différents potentiels à l'un des noeuds de raccordement (A1, A2, B1, B2), comprenant les étapes suivantes :
- commande du circuit d'attaque (31 ; 50) pour fournir les tensions de phase permettant de faire fonctionner la machine électrique (2) ;
- désactivation de la commande par modulation de largeur d'impulsion pour au moins l'un des disjoncteurs (36, 37 ; 52, 53) de manière à ce que ledit au moins un disjoncteur (36, 37 ; 52, 53) ne soit pas conducteur en permanence et à ce qu'il ne soit pas soumis au cadencement de la modulation de largeur d'impulsion et à ce qu'au moins pendant un intervalle de temps de chaque cycle de la modulation de largeur d'impulsion, aucun potentiel ne soit appliqué par le circuit d'attaque (31 ; 50) aux noeuds de raccordement (A1, A2, B1, B2), dans lequel le cycle est déterminé par la commande cyclique de la modulation de largeur d'impulsion ;
- détection pendant l'intervalle de temps d'une tension de diode à travers une diode de roue libre prévue sur le disjoncteur désactivé (36, 37 ; 52, 53) ;
- détermination du moment du passage par zéro du courant de phase comme étant le moment à partir duquel il n'existe plus de tension de diode, au cours de l'intervalle de temps, via la diode de roue libre (40 ; 54), dans lequel la tension de diode est provoquée par un courant de diode en sens passant ;
**caractérisé en ce que** la désactivation de la commande modulée en largeur d'impulsion pour au moins l'un des disjoncteurs (36, 37; 52, 53) est effectuée à l'intérieur d'une fenêtre temporelle de mesure, dans lequel seul le disjoncteur (36, 37 ; 52, 53) à travers lequel le courant de phase instantané provoque un courant de diode en sens passant est désactivé.

2. Procédé selon la revendication 1, dans lequel la fenêtre temporelle de mesure commence à un moment qui dépend d'un moment d'un changement de signe de la tension de phase ou correspond à celui-ci et se termine au plus tôt à un moment où le passage par zéro du courant de phase a été déterminé.

3. Procédé selon la revendication 2, dans lequel le disjoncteur (36, 37 ; 52, 53) à travers lequel le courant de phase instantané provoque un courant de diode en sens passant est déterminé par le gradient de la courbe de la tension de phase.

4. Procédé selon l'une des revendications 1 à 3, dans lequel le rapport cyclique est compris entre 30% et 70%.

5. Procédé pour déterminer la position de rotor d'un rotor d'une machine électrique (2), comprenant les étapes suivantes :
- détermination d'un moment de passage par zéro d'un courant de phase au moyen d'un procédé selon l'une quelconque des revendications 1 à 4 ;
- après détermination du moment du passage par zéro du courant de phase, détermination d'une ou de plusieurs tensions induites à travers le conducteur de phase (38, 39) dans une autre fenêtre temporelle de mesure, pendant que les disjoncteurs de la machine électrique qui sont associés au conducteur de phase ne sont pas conducteurs ;
- détermination de la position de rotor à partir de ladite au moins une tension induite, en déterminant les disjoncteurs (36, 37 ; 52, 53) associés à un conducteur de phase spécifique pour déterminer la position de rotor, pendant une autre fenêtre temporelle de mesure et la hauteur et/ou le gradient de la tension U_{ind} induite à travers le conducteur de phase (38, 39) et en déterminant le passage par zéro de la tension induite à partir du gradient et de la hauteur de la tension induite mesurée, dans lequel un moment du passage par zéro de la tension induite représente une mesure de la position de rotor.

6. Dispositif pour déterminer le moment d'un passage par zéro d'un courant de phase dans une machine électrique polyphasée (2) qui est commandée au moyen d'un circuit de commande (3 ; 31; 50) comportant des disjoncteurs (36, 37 ; 52, 53) en fournissant plusieurs tensions de phase qui sont appliquées à des noeuds de raccordement de la machine électrique (2) associés à des phases correspondantes, dans lequel les disjoncteurs (36, 37 ; 52, 53) sont respectivement montés en série entre un potentiel d'alimentation haut (V_{H}) et un potentiel d'alimentation bas (V_{L}), dans lequel le noeud de raccordement respectif (A1, A2, B1, B2) est prévu entre les disjoncteurs (36, 37 ; 52, 53), dans lequel au moins une partie des disjoncteurs peut être commandée cycliquement selon une modulation de largeur d'impulsion au moyen d'un rapport cyclique afin d'appliquer alternativement différents potentiels à l'un des noeuds de raccordement pour fournir la tension de phase respective,
dans lequel le dispositif est conçu
- pour commander le circuit d'attaque (3 ; 31 ; 50) pour fournir plusieurs tensions de phase permettant de faire fonctionner la machine électrique (2) ;
- pour désactiver la commande par modulation de largeur d'impulsion pour au moins l'un des disjoncteurs (36, 37 ; 52, 53) de manière à ce que ledit au moins un disjoncteur (36, 37 ; 52, 53) ne soit pas conducteur en permanence et à ce qu'il ne soit pas soumis au cadencement de la modulation de largeur d'impulsion et à ce qu'au moins pendant un intervalle de temps de chaque cycle de la modulation de largeur d'impulsion, aucun potentiel ne soit appliqué par le circuit d'attaque (3 ; 31 ; 50) aux noeuds de raccordement (A1, A2, B1, B2), dans lequel le cycle est déterminé par la commande cyclique de la modulation de largeur d'impulsion ;
- pour détecter pendant l'intervalle de temps une tension de diode à travers une diode de roue libre (40 ; 54) prévue sur ledit au moins un disjoncteur désactivé (36, 37 ; 52, 53), dans lequel la tension de la diode est provoquée par un courant de diode en sens passant ; pour déterminer le moment du passage par zéro du courant de phase comme étant le moment à partir duquel il n'existe plus de tension de diode, au cours de l'intervalle de temps, via la diode de roue libre (40 ; 54),
**caractérisé en ce que**
le dispositif est conçu pour effectuer la désactivation de la commande modulée en largeur d'impulsion pour au moins l'un des disjoncteurs (36, 37 ; 52, 53) à l'intérieur d'une fenêtre temporelle de mesure, dans lequel seul le disjoncteur (36, 37 ; 52, 53) à travers lequel le courant de phase instantané provoque un courant de diode en sens passant est désactivé.

7. Système moteur (1), comprenant :
- une machine électrique polyphasée (2) ;
- un circuit d'attaque (3) qui comporte des circuits onduleurs (34, 35, 51) respectivement pourvus d'un circuit série entre des disjoncteurs (36, 37 ; 52, 53) raccordés à un premier potentiel et à un second potentiel ;
- un dispositif selon la revendication 6.

8. Produit de programme informatique contenant un code de programme conçu, lorsqu'il est exécuté sur une unité de traitement de données, pour mettre en oeuvre le procédé selon l'une quelconque des revendications 1 à 6.
